# EUROPEAN PATENT APPLICATION

(11) **EP 3 349 093 A1**
(43) Date of publication of application: **18.07.2018**
(21) Application number: 18151149.4
(22) Date of filing: 11.01.2018
(51) Int. Cl.: G06F 1/16, H01F 27/02, H04B 5/00, H01Q 1/42, H05K 7/20

(54) **METAL AND CARBON LAMINATE TRANSMITTING ELECTROMAGNETIC WAVES OR HAVING FUNCTION OF HEAT RADIATION**

(30) Priority: 11.01.2017 KR 20170003975
(71) Applicant: Kim, Jae Beom, Seoul 06548 (KR)
(72) Inventor: Kim, Jae Beom, Seoul 06548 (KR)
(74) Representative: Pfenning, Meinig & Partner mbB

(57) **Abstract**

Disclosed herein is a metal and carbon laminate transmitting electromagnetic waves or having a function of heat radiation including a first layer configured of a carbon material, and a second layer configured of metal, wherein a groove is formed on at least one area of the second layer in order to allow the first layer to be exposed, thereby giving a characteristic of electromagnetic wave transmission, or wherein a slit is formed on the first layer along with the groove.

According to the above-described invention, the metal and carbon laminate transmitting electromagnetic waves or having a function of heat radiation may have an advantageous effect of being attached to an outer case of diverse devices that is configured of plastic, being equipped inside the device and, most particularly, being capable of enhancing the aesthetic external features of the device along with the heat radiation function by adding a metallic texture when applied to the outer case, and an advantageous effect of being installed at any position within the device regardless of the moving direction of the electromagnetic waves, thereby enabling an optimal selection of an installation position for heat radiation.

## Description

### BACKGROUND OF THE INVENTION

### Field of the Invention

The present invention relates to a metal and carbon laminate transmitting electromagnetic waves or having a function of heat radiation and, more particularly, to a metal and carbon laminate transmitting electromagnetic waves or having a function of heat radiation, wherein a groove having a predetermined width is formed on a portion (or area) of a metal layer of the metal and carbon laminate formed thereon so as to expose the carbon material, or a slit is also formed on the carbon material along with the groove, wherein, when the laminate is attached to a case of a device that is related to wireless charging or wireless communication or equipped inside the case, the metal and carbon laminate is capable of transmitting electromagnetic waves despite the presence of the metal layer, which has a general function of blocking out electromagnetic waves, and wherein a heat radiation function of the metal and carbon laminate prevents overheating of an applied device and allows stable usage of the corresponding device, thereby replacing the carbon group heat radiation element, which corresponds to the related art heat radiation element, or being used as the heat radiation element along with the carbon group heat radiation element.

### Discussion of the Related Art

As electronic products (or devices) have evolved to have the characteristics of high performance and compact size, high capacity and high-density integration are being realized in the electronic assembly parts, which are equipped inside the electronic devices. Accordingly, a larger amount of heat is being generated from the electronic devices. Such heat may reduce the duration of the devices or may cause errors, such as breakdown, malfunction, and so on. And, in some critical cases, this may also lead to explosion or fire. Most particularly, the generated heat cause degradation in sharpness and color of the display device, which eventually leads to a degradation in product reliability and stability. Accordingly, a system that can radiate the generated heat outside of the device or a system that can cool itself is being required.

One of the main methods for cooling the heat that is generated from an electronic device is to install a heat sink or a heat-radiating fan. Herein, in case of installing a heat sink, the heat radiation efficiency becomes extremely low, since the amount of heat generated from the electronic device is larger than the amount of heat that can be emitted through the heat sink. Additionally, in case of installing a heat-radiating fan, it will be disadvantageous in that noise and oscillation may be generated, not to mention that such fan cannot be applied in electronic devices that are required to be light-weight and slim-sized, such as laptop computers, mobile devices, and so on. Therefore, a sheet-type heat radiation element is generally used in electronics devices that require light-weight and slim size.

Recently, carbon material sheets (or graphite sheets), which are light-weight and slim-sized and have excellent conductivity, have been widely used as the heat radiation element.

In a broader meaning, carbon is a type of carbon material being manufactured at a higher temperature as compared to general carbon. Thus, carbon is highly resistant to heat and has excellent elasticity. Before using the above-described carbon material heat radiating sheets, heat radiating sheets configured of highly conductive metal, such as silver, copper, aluminum, and so on, were used.

Herein, metallic heat radiating sheets generally radiate heat along a longitudinal direction, whereas carbonic heat radiating sheets generally radiate heat along a lateral direction.

However, when the metallic heat radiating sheet is intended to be applied to a device having the characteristics of transmitting electromagnetic waves, such as wireless chargers, mobile phones, NFCs, and so on, the metallic heat radiating sheet cannot be applied to the devices listed above due to its characteristics of blocking out electromagnetic waves. Most particularly, it is impossible to install the heat radiating element at a position where the electromagnetic waves pass through. Therefore, in this case, a problem existed in that it was inevitable to use only the carbon material heat radiation element.

This is a disadvantage because, in the aspect of obtaining raw materials, or in the aspect of easy processing, metal is more excellent than carbon. Therefore, a technology enabling metallic heat radiating sheets to be used along with an assembly part capable of transmitting electromagnetic waves is required.

### SUMMARY OF THE INVENTION

Accordingly, the present invention is directed to a metal and carbon laminate transmitting electromagnetic waves or having a function of heat radiation that substantially obviates one or more problems due to limitations and disadvantages of the related art.

A technical object of the present invention is to provide a metal and carbon laminate transmitting electromagnetic waves or having a function of heat radiation, wherein an electromagnetic wave blocking function of metal is removed by providing a groove or slit on at least a portion of the metal layer, thereby maintaining the functions of wireless charging, near field communication, mobile payment, and so on, of the device.

Another object of the present invention is to provide a metal and carbon laminate transmitting electromagnetic waves or having a function of heat radiation that can be installed at any position within the device regardless of the moving direction of the electromagnetic waves, thereby enabling an optimal selection of an installation position for heat radiation.

Yet another object of the present invention is to provide a metal and carbon laminate transmitting electromagnetic waves or having a function of heat radiation that can maintain its lightweight by maintaining the usage of its outer case, which is configured of plastic.

Yet another object of the present invention is to provide a metal and carbon laminate transmitting electromagnetic waves or having a function of heat radiation that can add diversity in colors that are recognized through the slit formed on an upper frame, by layering a plurality of frames one over another and by applying different colors to each of the metal layers and/or carbon material. Thus, the aesthetic external features of the device may be enhanced.

Yet another object of the present invention is to provide a metal and carbon laminate transmitting electromagnetic waves or having a function of heat radiation that can maximize heat radiation efficiency of the device by using the metal and carbon laminate as a heat radiation means, wherein the metal and carbon laminate may be used as a replacement for a carbon material heat radiation element, which corresponds to the related art heat radiation means, or wherein the metal and carbon laminate may be used in combination with the carbon material heat radiation element.

A further object of the present invention is to provide a metal and carbon laminate transmitting electromagnetic waves or having a function of heat radiation that can enhance the performance of an NFC module and an installation device by amplifying (or increasing) the transmission/reception rate of the NFC module, since the multi-layer structure of the metal and carbon laminate performs the function of an antenna, in case the metal and carbon laminate is layered in a multi-layer structure.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, according to an exemplary embodiment of the present invention, provided herein is a metal and carbon laminate transmitting electromagnetic waves or having a function of heat radiation including a first layer configured of a carbon material, and a second layer configured of metal, wherein a groove is formed on at least one area of the second layer in order to allow the first layer to be exposed, thereby giving a characteristic of electromagnetic wave transmission, or wherein a slit is formed on the first layer along with the groove.

Preferably, a boundary between the slit or groove and the second layer may be formed in one of straight lines, curved lines, and spiral lines.

Preferably, the slit may be extended to form at least one pattern consisting of one of straight lines, curved lines, and spiral lines.

Preferably, the groove may be formed or processed by using at least of one of 3D printing, laser treatment, sawing, drilling, cutting, and etching, and the slit may be formed or processed by using at least one of 3D printing, sawing, laser treatment, punching, and etching.

Preferably, the first layer may be formed by using at least of one of 3D printing, spray coating, printing, vacuum evaporation, dipping, transferring, and adhesion.

Preferably, the second layer may be formed by using at least one of 3D printing, plating, coating, printing, vacuum evaporation, molding, pressing, rolling, and adhesion.

Preferably, the second layer may include aluminum or copper.

Preferably, the laminate may be installed at a position corresponding to a main transmitting direction or a main receiving direction of a transmitting unit or receiving unit of wireless power or wireless charging included in the device.

Preferably, a plurality of laminates may be layered in a multi-layer structure on a near field communication (NFC) module included in the device, thereby amplifying an electromagnetic field.

Preferably, the plurality of laminates may be layered so that patterns of the groove or slit are vertically identical to one another, or that patterns of the groove or slit are alternated, and an uppermost laminate may be required to have a slit formed thereon.

Preferably, the laminate may replace a conventional carbon heat radiation element configured in a device or layered along with the conventional carbon heat radiation element.

Preferably, a plurality of laminates may be layered one over another, and wherein a color of a lower laminate is recognized through a slit of an upper laminate.

Preferably, a lower second layer and an upper second layer may be configured to have different colors so that the color of the lower second layer is recognized through the slit of the upper laminate.

Preferably, a lower first layer and an upper first layer may be configured to have different colors so that the color of the lower first layer is recognized through the slit of the upper laminate.

Preferably, the plurality of metal and carbon laminates may be layered one over another, an insulating layer may be further included between each laminate, and the insulating layer may correspond to any one of air, a laminate, and a coating layer.

Preferably, the insulating layer and the upper laminate may be configured to have different colors so that the color of the insulating layer is recognized through the slit of the upper laminate.

Preferably, when a slit is formed on an upper laminate, and when the plurality of metal and carbon laminates is layered one over another, a pattern of a lower laminate may be configured to not overlap with a pattern of an upper laminate, thereby allowing a groove or slit formed on the lower laminate to be hidden.

Preferably, the metal and carbon laminate may be connected to a substrate so as to be applied to a mobile device and used as an antenna.

Preferably, an average width of a groove or slit may be equal to or less than 2 times an average width between two adjacent grooves or slits.

Preferably, the groove or slit may be a width exceeding 0 and less than or equal to several millimeters (mm).

Preferably, a substance of the first layer may fill at least a portion of the groove.

Preferably, an area where the groove or slit is formed may be larger than an area occupied by a wireless transmitting/receiving module for transmitting electromagnetic waves, and an entire area occupied by the wireless transmitting/receiving module may be positioned to overlap with at least a portion of the area where the slit is formed.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 illustrates a perspective view showing a metal and carbon laminate according to a preferred embodiment of the present invention.
FIG. 2 illustrates a detailed view showing a metal layer according to a preferred embodiment of the present invention.
FIG. 3 illustrates a detailed view showing a groove or slit according to a preferred embodiment of the present invention.
FIG. 4 illustrates a detailed view showing examples of a groove or slit according to a preferred embodiment of the present invention.
FIG. 5 illustrates a detailed view showing examples of an edge of a groove or slit according to a preferred embodiment of the present invention.
FIG. 6 illustrates cross-sectional views each showing an example of a metal and carbon laminate according to a preferred embodiment of the present invention.
FIG. 7 illustrates a cross-sectional view showing another example of a metal and carbon laminate according to a preferred embodiment of the present invention.
FIG. 8 illustrates cross-sectionals view showing yet another example of a metal and carbon laminate according to a preferred embodiment of the present invention.
FIG. 9 illustrates a graph showing measurements of a heat radiation characteristic respective to slit distances of a metal frame by using a time function according to a preferred embodiment of the present invention.
FIG. 10 illustrates a cross-sectional view showing another example of a metal and carbon laminate according to a preferred embodiment of the present invention.
FIG. 11 illustrates a perspective view and a plane view showing a layered status during a process of forming a groove of a metal and carbon laminate according to a preferred embodiment of the present invention.
FIG. 12 illustrates a perspective view and a plane view showing a layered status during a process of forming a slit of a metal and carbon laminate according to a preferred embodiment of the present invention.
FIG. 13 illustrates a cross-sectional view showing a layered structure according a preferred embodiment of the present invention.
FIG. 14 illustrates a detailed view showing an exemplary comparison of overlapping status between an area of a metal and carbon laminate and an area occupied by a module according to a preferred embodiment of the present invention.

### DETAILED DESCRIPTION OF THE INVENTION

Hereinafter, the exemplary embodiments of the present invention will be illustrated in the appended drawings and described in detail in the detailed description of the present invention. In describing the present invention, when it is determined that the detailed description on a related disclosed technology may cause ambiguity in the concept (or idea) of the present invention, the detailed description of the same will be omitted for simplicity.

The terms used in the description of the present invention are defined based on their corresponding functions within the present invention. And, since the meaning of such terms may vary in accordance with the intentions or practices of anyone skilled in the art, the definition of the terms used in the description of the present invention should be understood based on the overall context of this specification.

In the present invention, although a mobile phone, which corresponds to a mobile device, is described as a main exemplary embodiment of the device adopting the metal and carbon laminate, the present invention will not be limited only to this. And, therefore, the present invention may also include laptop computers, wearable devices, wireless chargers, and so on. Additionally, by extending its scope of application, the present invention may also be applied to built-in charging devices, and other non-mobile devices, such as electric appliances. More specifically, since the present invention may be applied to any device being equipped with a function of radiating heat or a function of transmitting electromagnetic waves, there is no particular limitation in the types of devices to which the present invention may be applied.

Additionally, the area where the metal and carbon laminate is formed will not be limited only to a case of the corresponding device. And, therefore, the metal and carbon laminate according to the present invention may also be equipped inside the corresponding device. Moreover, the texture of the metal will not be separately limited.

Additionally, a metal layer (second layer) may not be configured only of a 100% metallic substance, which has a function of transmitting electromagnetic waves or a function of radiating heat. In the description of the present invention, it will be preferable to interpret that the metal layer includes metal as its main substance.

Additionally, the characteristic that the metal layer includes metal as its main substance indicates that metal occupies the highest portion as compared to other substances configuring the metal layer.

The metal layer may be formed of substances having diverse properties, such as paste, liquid, and so on.

Moreover, although a two-dimensional (2D) plate may be generally selected as the shape of the metal and carbon laminate, it will be apparent that the shape of the metal and carbon laminate according to the present invention will not be limited only to the two-dimensional or plate shape.

Additionally, in the description of the present invention, a groove refers to a space that is formed by a partial loss of the metal layer in a state where the carbon material remains. Herein, the carbon material is exposed through the groove of the metal layer. More specifically, the groove is a feature that only applies to the metal layer. However, the carbon material is not necessarily required to be recognized through the naked human eye. And, therefore, the present invention also includes a case when the gap of the groove is configured of a minute size that only allows the carbon material to be verified by being magnified through a magnifying glass. In other words, the width (or gap) of the groove will not be limited to a specific number (or size).

Meanwhile, a slit refers to a gap (or crack), which is formed on an object and through which light can be passed. In other words, the slit refers to a gap (or crack) formed on the carbon material (first layer). More specifically, the slit is a feature that only applies to the carbon material. Herein, the width (or gap) of the slit will not be limited to a specific number (or size).

The position where the groove is formed may or may not match with the position where the slit is formed. More specifically, the position where the slit is formed may be located outside of the position where the groove is formed.

The metal layer is required to include a groove, and the carbon material may or may not include a slit.

Furthermore, the slit and the groove may be formed at matching positions or may each be formed at different positions.

In the description of the present invention, the terms carbon material and first layer may be alternately used, and the terms metal or metal layer and second layer may be alternately used.

The present invention shall not separately limit the laminating method when performing lamination, the thickness of the laminate or the number of laminates, the number of lamination sessions, and so on, and shall include all cases. More specifically, even in a case where only one layer of a metal or carbon material thin film layer is formed on a bulk of carbon material or a metallic substance having a groove formed thereon, the carbon material and the metallic substance configured a laminated structure (or a layered structure). In other words, the meaning of lamination corresponds to the broadest meaning of the combination (or layering) between all layers.

Herein, several nanometers, several micrometers, several millimeters, and so on, respectively refer to a range starting from 1 or more to less than 10 nanometers, a range starting from 1 or more to less than 10 micrometers, a range starting from 1 or more to less than 10 millimeters, and so on. Also, several tens of nanometers, several tens of micrometers, several tens of millimeters, and so on, respectively refer to a range starting from 10 or more to less than 100 nanometers, a range starting from 10 or more to less than 100 micrometers, a range starting from 10 or more to less than 100 millimeters, and so on. Furthermore, a sub-nanometer, a sub-micrometer, a sub-millimeter, and so on, respectively refer to a range starting from 0.1 or more to less than 1 nanometer, a range starting from 0.1 or more to less than 1 micrometer, a range starting from 0.1 or more to less than 1 millimeter, and so on.

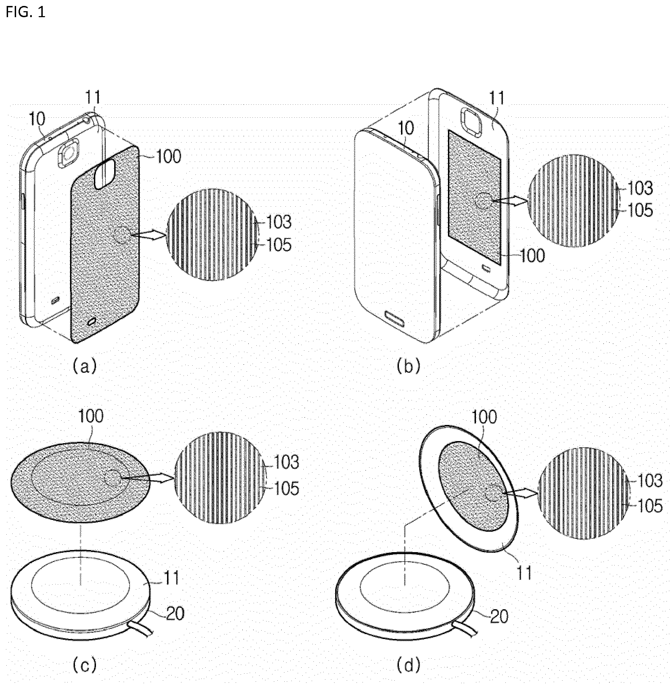

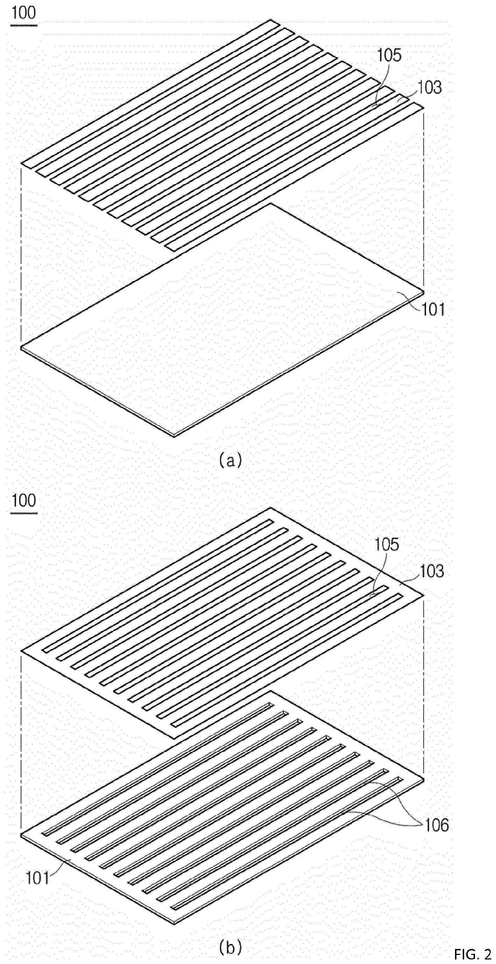

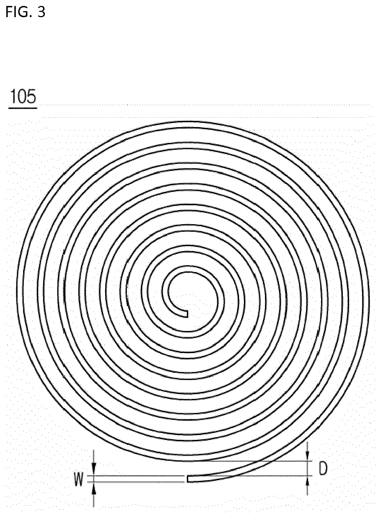

FIG. 1 illustrates a perspective view showing a metal and carbon laminate according to a preferred embodiment of the present invention. FIG. 2 illustrates a detailed view showing a metal layer. And, FIG. 3 illustrates a detailed view showing a groove or slit.

As shown in the drawings, in case the metal and carbon laminate 100 is attached to an outer plastic case 11 of a mobile device 10 or a wireless charger 20 so that the metallic part is exposed to the outside, this may add the visual effect of metallic texture and may also enhance the aesthetic external features of the metal and carbon laminate 100. However, as described above, the metal and carbon laminate 100 may not only be applied to the exterior of the device but may also be applied to the interior of the device without limitation.

The above-described metal and carbon laminate 100 may be configured by having one surface of a first layer 101 attached to the mobile device 10 and by having a second layer 103 formed on another surface of the first layer 101.

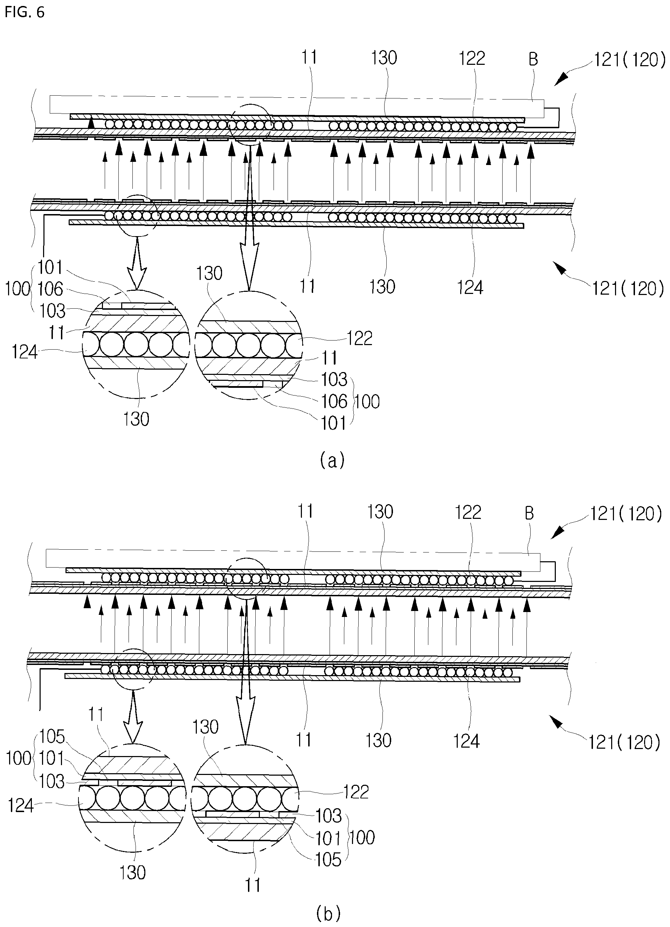

Herein, in case the first layer 101 is applied to the exterior of the case 10, the first layer 101 may be directly attached to the case 10 or may be attached to the case 10 by using an insulating layer 110 as a medium, as shown in FIG. 6.

The first layer 101 may be laminated (or layered) on the second layer 103 by using at least one method selected from 3D printing, coating, printing, vacuum evaporation, and adhesion of metal laminates, and so on.

Additionally, the second layer 103 may be laminated on the first layer 101 by using at least one method selected from 3D printing, plating, coating, printing, vacuum evaporation, and adhesion of metal laminates, and so on. More specifically, both the first layer 101 and the second layer 103 may correspond to a bulk, or any one of the first layer 101 and the second layer 103 may correspond to a bulk and the other may correspond to a coating layer formed thereon.

Meanwhile, at least a portion of the second layer may fill the slit of the first layer, and at least a portion of the first layer may fill the groove of the second layer. However, the second layer is required to include a groove that is large enough to expose the first layer or the slit formed on the first layer.

More specifically, the method for forming the above-described first layer 101 and the second layer 103 will not be limited only to the examples listed above.

In order to add the characteristics of heat radiation or electromagnetic wave transmission to the second layer 103, a groove 105 may be formed on at least an area of the second layer 103. And, the first layer 101 may be exposed through the groove 105. The groove 105 may be formed on the second layer 103 according to predetermined patterns or may be formed by processing a surface of the second layer 103 having no patterns. Additionally, the slit 106 may be formed by processing the first layer 101, or the first layer 101 may be configured so that the slit 106 is originally (or essentially) formed thereon.

The groove 105 may be formed or processed by using at least one method selected from plasma treatment, 3D printing, laser treatment, drilling, sawing, cutting, and etching. Alternatively, the groove 105 may also be formed by performing printing, plating, vacuum evaporation, spray coating, and so on, on a substrate, such as a film. At this point, the film may or may not be removed. Furthermore, a groove may also be naturally formed by forming the metal layer (or second layer) by using any one of methods including molding, pressing, rolling, and so on.

Meanwhile, in case of forming a carbon material (or first layer) on the second layer, any one of the methods including vacuum evaporation, printing, spray coating, 3D printing, dipping, transferring, adhesion, and so on.

Also, the slit may be formed or processed by using at least one method selected from 3D printing, sawing, laser treatment, punching, and etching.

Although it is preferable that the groove 105 and the slit 106 has a width (W) greater than 0 and less than or equal to several millimeters (mm), the range of the width may be expanded within a range of maintaining the characteristics of electromagnetic wave transmission or heat radiation. Furthermore, in order to ensure the beauty of the exterior of the frame, the range of the width may be limited to a predetermined range. Nevertheless, if the width is formed outside of the above-mentioned range, although there is no significant change in the characteristic of electromagnetic wave transmission, the characteristics of heat radiation may be degraded.

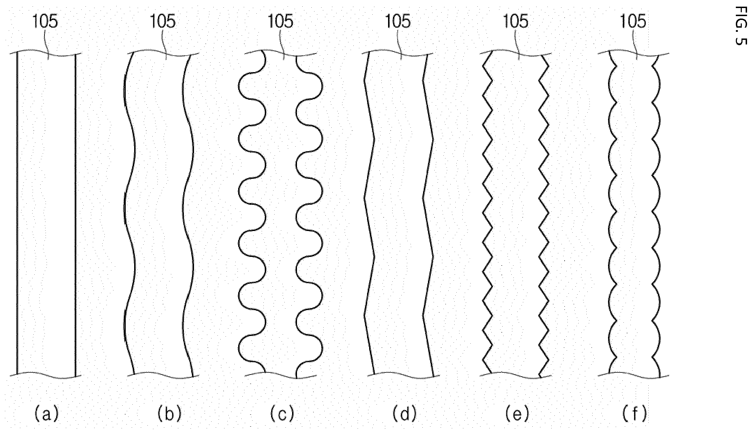

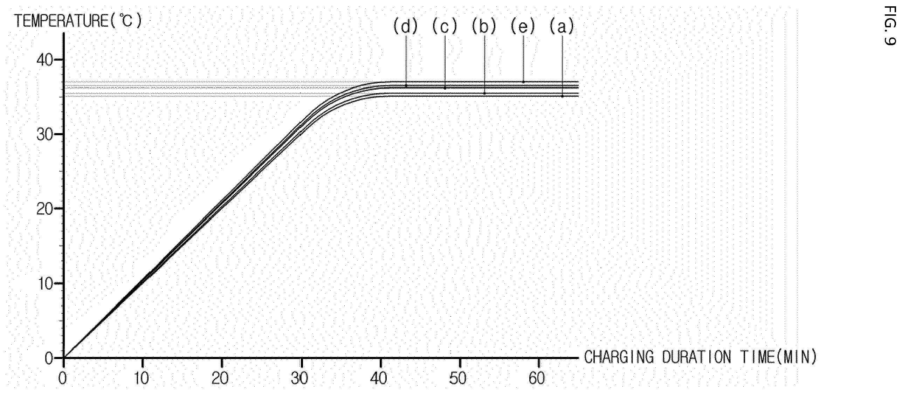

The wireless transmitting/receiving module 120 may correspond to a receiving unit for wireless charging 121, as shown in FIG. 5 and FIG. 9, and, evidently, the transmitting unit 123 may correspond to an NFC module 125, an MST module 127, which is used as a means of mobile payment, such as Samsung Pay, and so on.

Additionally, when deciding the width of the groove 105 or the slit 106, the aesthetic external features may also be an issue that should be taken into consideration. In case the width of the groove 105 or the slit 106 becomes excessively large to be recognized by the naked human eye, the characteristics of electromagnetic wave transmission or heat radiation may become a separate issue, since the aesthetic external features become significantly degraded. Therefore, such features should be taken into consideration when deciding the width of the groove or slit.

In other words, since the groove 105 or slit 106 that is formed to have a width ranging from sub-nanometer units to several tens of micrometer units is not easily recognized by the naked human eye, and since such groove 105 or slit 106 has no significant difference as compared to the metal and carbon laminate 100, which does not have any groove 105 or slit 106 formed thereon, if a metal and carbon laminate 100 having a texture that is very similar to a metal and carbon laminate 100 having no groove 105 or slit 106 formed thereon is wanted, it is preferable to limit the width of the groove 105 or slit 106 to the above-described range. And, in this case, the width of the groove 105 or slit 106 has a critical significance.

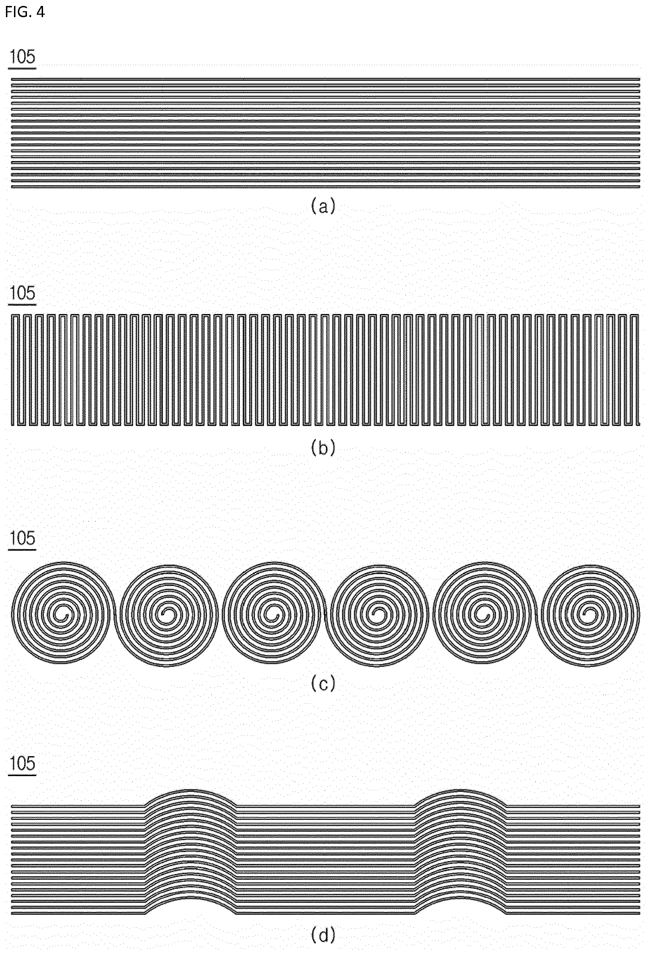

As shown in FIG. 4, the groove 105 or slit 106 may show patterns formed in straight lines (FIG. 4a), curved lines (FIG. 4b), and spiral lines (FIG. 4c). Alternatively, the groove 105 or slit 106 may also show patterns formed of a combination of any two of the above-described patterns (FIG. 4d). Also, as shown in FIG. 5, the boundary between the groove 105 and the second layer 103 or the boundary between the slit 106 and the second layer 103 may show single-shaped patterns formed in straight lines, curved lines, spiral lines, an a bulgy-and-hollow structure, and so on, or combined patterns configured of a random combination of any two of the above-described patterns.

For example, in case of forming a slit 106 by using the punching process, if the punching process is continuously performed so that the holes formed by each punching process can overlap with one another, the boundary of the slit 106 forms a shape shown in FIG. 5f.

At this point, as shown in FIG. 3, it is preferable that an average value of the width (W) of the groove 105 or slit 106 is less than or equal to 2 times the average value of a distance (D) between two neighboring grooves 105 or slits 106. And, in this case, electromagnetic waves may be easily transmitted by passing through the second layer 103.

The above-described slit 106 may be formed on the entire second layer 103 or a part of the second layer 103. And, more specifically, as shown in FIG. 6, the slit 106 may be partially formed on an area corresponding to a position of the wireless transmitting/receiving module 120.

This will hereinafter be described in more detail.

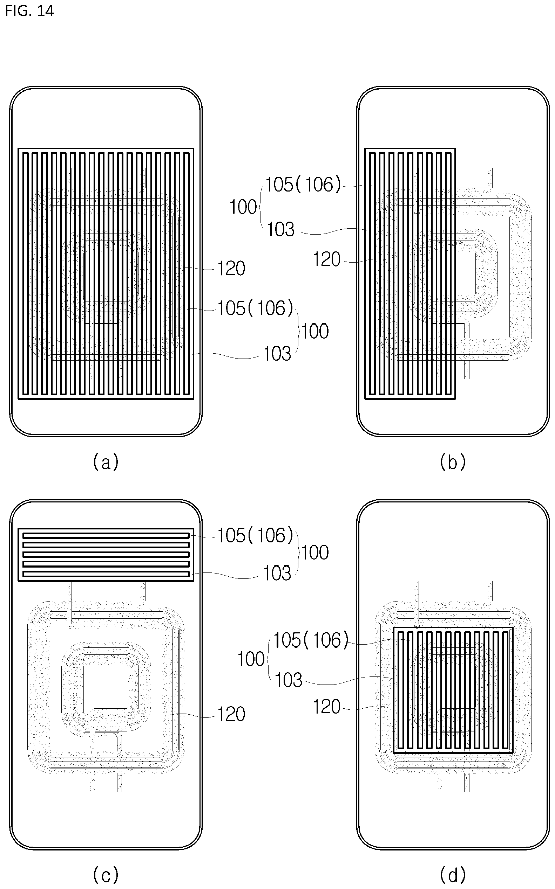

The areas where the above-described grooves 105 or slits 106 are formed may be applied throughout the entire frame 100. However, when required, the grooves 105 or slits 106 may be partially formed on an area corresponding to an area where the wireless transmitting/receiving module 120 is provided. However, the area where the grooves 105 or slits 106 are formed should be larger than the area occupied by the wireless transmitting/receiving module 120, as shown below in FIG. 14. Herein, (a) of FIG. 14 illustrates a preferred embodiment of the present invention, wherein the overall area of the wireless transmitting/receiving module 120 is overlapped by a groove 105 or slit 106 area that is larger than the overall area of the wireless transmitting/receiving module 120, and (b) to (d) of FIG. 14 illustrate non-preferred embodiments of the present invention. More specifically, (b) corresponds to a case when the groove 105 or slit 106 area is positioned to overlap only a part of the module 120, (c) corresponds to a case when the groove 105 or slit 106 area is positioned to not overlap the module 120 at all, and (d) corresponds to a case when the groove 105 or slit 106 area is smaller than the area of the module 120. Since an eddy current occurs in all of the above-described cases, none of the above-described cases (b) to (d) is preferable for the transmission of electromagnetic waves. In other words, referring to FIG. 14(a), in case of forming a virtual edge on an outermost edge of the area where the grooves 105 or slits 106 are formed, this indicates that the wireless transmitting/receiving module 120 should be located within the virtual edge.

Herein, it will be apparent that the patterns of the slit 106 shown in FIG. 14(a) are not limited only to the patterns shown in FIG. 14(a). Most particularly, the area where the grooves 105 or slits 106 are formed should be larger than the area occupied by the wireless transmitting/receiving module 120 for transmitting electromagnetic waves, and the overall area occupied by the wireless transmitting/receiving module 120 should be positioned within at least a part of the area where the grooves 105 or slits 106 are formed (so as to be covered and/or overlapped by the corresponding area). If the area where the grooves 105 or slits 106 are formed overlaps only a part of the area occupied by the module 120 or does not overlap at all the area occupied by the module 120, or in case the area occupied by the module 120 is smaller than the area where the grooves 105 or slits 106 are formed, an eddy current may be generated during the process of transmitting the electromagnetic waves. And, accordingly, since the transmission of the electromagnetic waves is not performed easily, in case of communication, transmission/reception sensitivity may be degraded, or, in case of wireless charging, the duration of the charging time may be extended. For example, in case of a disclosed slot antenna, an eddy current may be generated within a slot of a metal plate, wherein the slot is formed on the metal plate due to the electromagnetic waves that are emitted from an electromagnetic wave emitting module. And, a magnetic flux within the slot may be increased by using the generated eddy current. Thus, due to the magnetic flux of the metal plate itself, the metal plate having a slot formed thereon may be capable of performing the function of an antenna having diverse capabilities. However, instead of actively performing a specific function (e.g., antenna function) associated with the transmission and/or reception of electromagnetic waves, such as the slot antenna, since the non-conductive frame having the grooves 105 or slits 106 formed thereon does not perform any function associated with the transmission and/or reception of electromagnetic waves, it may be said that the two technologies are not correlated to one another. Therefore, the slot antenna should not be identified as the present invention, and the slot antenna should not be considered to be within the same or similar technical scope of the present invention. In other words, the slot antenna should be considered as a completely different technology. Herein, the term "overlapping" indicates that the slit area of the metal frame is positioned to be above the area occupied by the module at a predetermined distance.

FIG. 6 illustrates cross-sectional views each showing an example of a metal and carbon laminate according to a preferred embodiment of the present invention.

As shown in the drawing, for example, the metal and carbon laminate 100 may be attached to a position of the outer case 11 corresponding to positions where a receiver 121 and a transmitter 123 for wireless charging included in the wireless transmitting/receiving module 120 exist.

In the present invention, the metal and carbon laminate 100 is attached to the outer case 11 of a mobile device, and the temperature is measured while charging the mobile device. The charging is carried out for 35 minutes.

As a result, the case 11 that is attached to the metal and carbon laminate 100 marked a temperature of approximately 36 degrees Celsius (36°C), which indicates that there is no problem in the durability of wireless charging.

According to the above-described result, it is apparent that the metal and carbon laminate 100 has an excellent heat radiation characteristic.

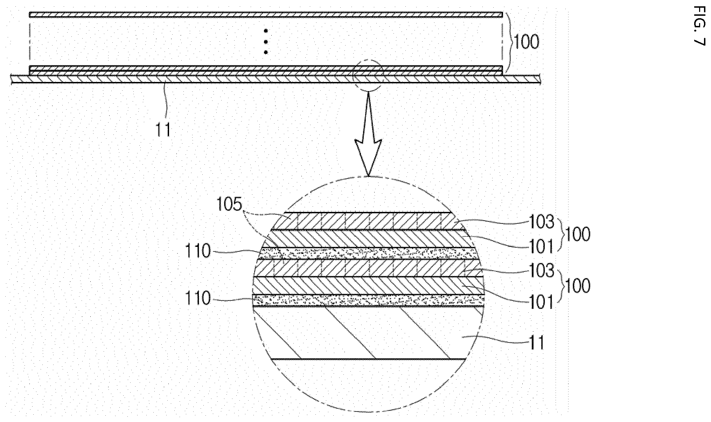

The above-described metal and carbon laminate 100 may be attached to the case 11 as a single layer or may be attached to the case 11 in a multi-layer structure, as shown in FIG. 7. This will hereinafter be described in more detail with reference to the accompanying drawing. The exemplary embodiment of the multi-layered adhesion (or attachment) of the metal and carbon laminate 100 is also not limited only to the exterior of the case but may also be equally applied to the interior of the case.

FIG. 7 illustrates a cross-sectional view showing another example of a metal and carbon laminate according to a preferred embodiment of the present invention.

As shown in the drawing, the metal and carbon laminate 100 according to the present invention is layered in a multi-layer structure. Herein, each layer of the metal and carbon laminate 100 is given a different color. Thereafter, if the slit 106 of the upper laminate and the groove 105 or slit 106 of the lower laminate are positioned so that they do not overlap with one another, the color of the lower laminate may be faintly recognized through the slit 106 of the upper laminate. And, by using this method, diverse colors may be implemented by the multi-layered structure of the metal and carbon laminate 100. However, in this case, a slit 106 is required to be formed on an uppermost laminate 100. This is because the first layer is non-transparent.

Additionally, the metal and carbon laminate 100 may be layered on the case 11. Herein, the layering may be performed by using an insulating layer 110 as a medium. The insulating layer 110 may corresponds to any one of a means of adhesion, a film, and a coating layer given a predetermined color. Accordingly, the color of the lower insulating layer 110 may be revealed through the slit 106 of the upper metal and carbon laminate 100. Herein, the insulating layer 110 is merely used as a means for revealing its color.

Meanwhile, when layering metal and carbon laminates 100 one over another, in case the groove 105 or slit 106 of the lower laminate and the slit 106 of the upper laminate do not overlap with one another at all, the groove 105 or slit 106 of the lower laminate may be completely hidden. At this point, the aesthetic external features that can be obtained from the metal and carbon laminate 100 may be adjusted. In this case, there is no change in the characteristic of electromagnetic wave transmission of the metal and carbon laminate 100.

In order to examine the heat radiation characteristic of the metal and carbon laminate 100, the metal and carbon laminate 100 being processed to have a groove 105 or a groove 105 or a slit 106 formed thereon is applied to the outer case of the mobile device. Thereafter, when wireless charging is carried out, the measured temperature is examined. The charging is carried out for approximately 1 hour.

As a result, at the point when 40 minutes is passed, the outer case of the device according to the present invention marks a temperature range of approximately 35 to 37°C, which indicates that there is no problem in the durability of wireless charging. Generally, in case the temperature being measured from the outer case of the corresponding device during wireless charging is equal to 45°C or below, it is understood that there is no significant problem. Accordingly, the metal and carbon laminate 100 according to the present invention has no default in being applied to the outer case of a wireless charging device or a mobile device, and so on.

Due to its excellent thermal conductivity, metal may be the most preferable heat radiation material. However, when metal is applied to the wireless transmitting/receiving module 120, a problem of blocking the electromagnetic waves may occur. Accordingly, as long as the metallic substance blocks the electromagnetic waves, metal cannot be used as a heat radiation material of the device having the function of transmitting or receiving electromagnetic waves. Therefore, instead of using metal, heat radiation elements of the carbon group and, most particularly, a carbon material 130 has been generally used as the heat radiation means of the wireless transmitting/receiving module 120.

However, since a groove 105 or slit 106 is provided on the metal and carbon laminate 100, even if the second layer 103 is mainly configured of a metallic substance, the electromagnetic waves may be transmitted by passing through the groove 105 or slit 106, the second layer 103 may also be applied as the means of heat radiation of the wireless transmitting/receiving module 120.

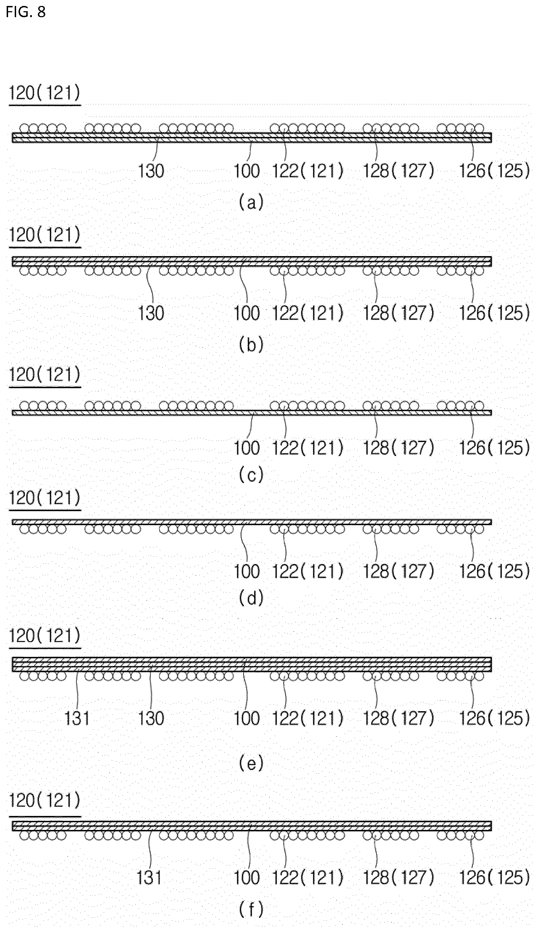

In this case, as shown in FIG. 8a and b, the metal and carbon laminate 100 may be layered along with the carbon material 130. Alternatively, as shown in FIG. 8c and d, the metal and carbon laminate 100 may also be used by replacing the carbon material 130. Herein, the carbon material corresponds to a carbon group substance, and, therefore, it will be apparent that the graphite may also be replaced with any other substance belonging to the carbon group.

Moreover, a magnetic sheet 131 may be further deposited on the wireless transmitting/receiving module 120. And, therefore, the magnetic sheet 131 may be used by being layered with the metal and carbon laminate 100, or the magnetic sheet 131 may be used by being layered with the metal and carbon laminate 100 and the carbon material 130 heat radiation element. In this case, the layering order of the magnetic sheet 131, the metal and carbon laminate 100, and the carbon material 130 heat radiation element may include all number of cases. Herein, the magnetic sheet 131 performs the same function as the conventional wireless transmitting/receiving module.

In FIG. 9, metal and carbon laminates 100 each having a groove 105 or slit 106 width of 0.01mm (a), 1mm (b), 10mm (c), and 15mm (d) are respectively shown in the form of a temperature function with respect to time, and each temperature function is indicated in comparison with the carbon material (e), which corresponds to the standard material.

As shown in the drawing, in case the width of the groove 105 or slit 106 is equal to 15mm, its saturation temperature marks the highest level of approximately 36.5°C. Subsequently, as the width of the groove 105 or slit 106 decreases, it was apparent that the saturation temperature also decreases accordingly. When using the carbon material, which corresponds to the standard material, the saturation temperature marked 37°C. Therefore, it can be understood that the metal and carbon laminate 100 according to the present invention has no default in being used as the heat radiation material of the corresponding device.

In conclusion, when using the metal and carbon laminate 100 having a groove 105 or slit 106 formed thereon according to the present invention, over-heating of the wireless transmitting/receiving module 120 may be prevented. Accordingly, this is advantageous in that safety-related accidents, which are caused by such overheating, can be prevented, and that damage caused to the device can also be prevented.

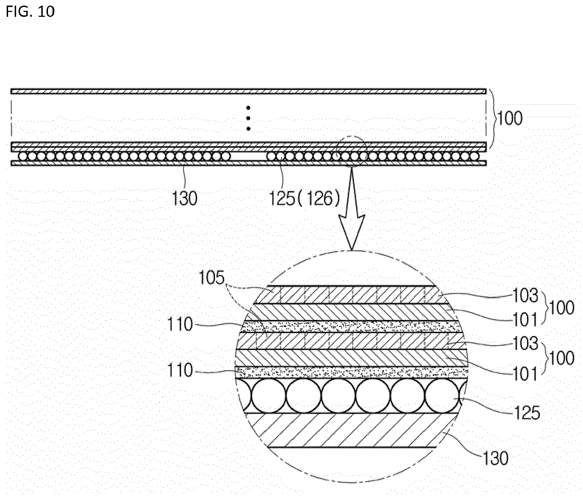

FIG. 10 illustrates that the metal and carbon laminate 100 is positioned on a receiving unit coil 122, an NFC coil 126, and an MST coil 128, which correspond to the source of heat radiation, as a single layer or in combination with the carbon material 130.

Meanwhile, the metal and carbon laminate 100 may be used as a means for transmitting power as well as an antenna for amplifying electromagnetic waves. As shown in FIG. 10, since the metal and carbon laminate 100 is layered in a multi-layer structure along a transmitting/receiving direction of the NFC module (i.e., the direction along which the electromagnetic waves are transmitted), the multi-layer of metal and carbon laminates 100 may perform the function of an antenna for amplifying a weak electric field. This has been experimentally verified and configures one of the characteristics of the present invention.

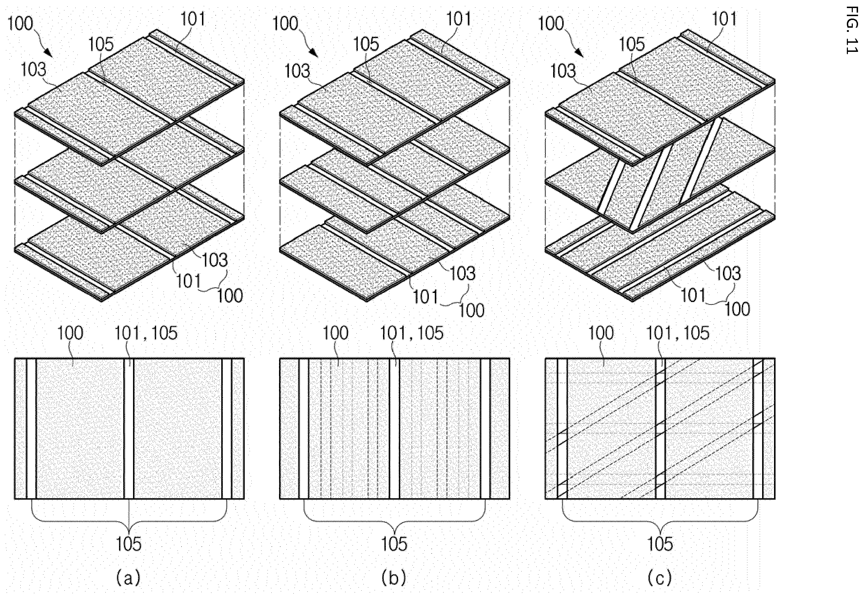

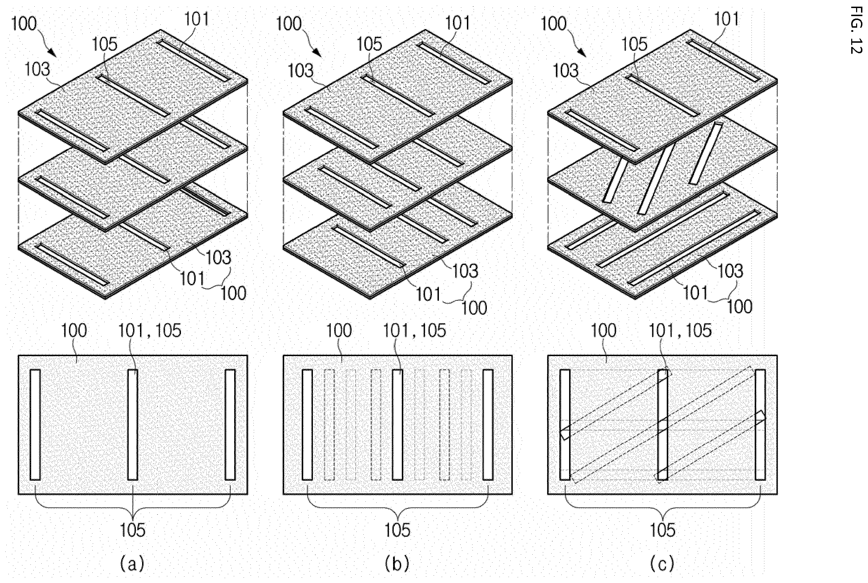

FIG. 11 illustrates a perspective view and a plane view showing a layered status during a process of forming a groove 105 of a metal and carbon laminate according to a preferred embodiment of the present invention. And, FIG. 12 illustrates a perspective view and a plane view showing a layered status during a process of forming a slit 106 of a metal and carbon laminate according to a preferred embodiment of the present invention.

As shown in the drawing, a case (a) when the grooves 105 or slits 106 of the metal and carbon laminate 100 are layered so as to overlap with one another at the same positions, a case (b) when the grooves 105 or slits 106 are layered so that they do not overlap with one another at all, and a case (c) when the grooves 105 or slits 106 are layered so that they partially overlap with one another may be implemented. In this case, however, a slit 106 is required to be formed on an uppermost laminate 100 so that the color of the lower laminate 100 can be recognized.

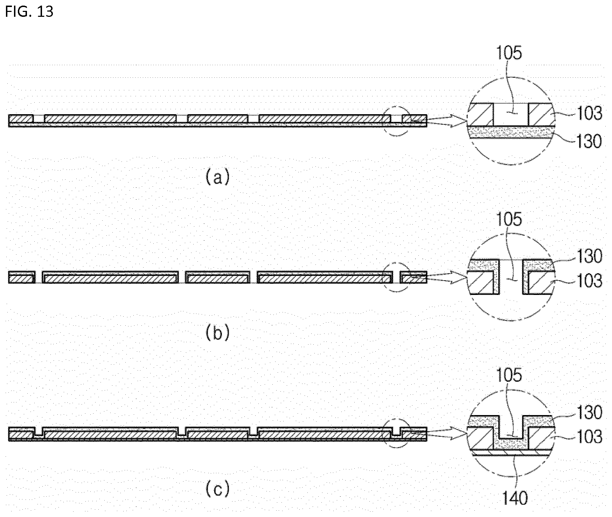

FIG. 13 illustrates a cross-sectional view showing a layered structure according a preferred embodiment of the present invention.

As shown in the drawing, according to one layering order, the second layer 103 may be formed on the first layer 101 (a), and according to another layering order, the first layer 101 may be formed on the second layer 103 (b), and a non-conductive film 140 may be adhered under the second layer 103. The first layer 101 may form a state of filling at least a part of the groove of the second layer 103.

As described above, the characteristics of transmitting electromagnetic waves and radiating heat are given at the same time to a second layer 103 having a general function of blocking electromagnetic waves by providing a groove 105 on the second layer 103 of the metal and carbon laminate 100 or by providing the groove 105 and a slit 106 on the first layer 101 according to the present invention. Accordingly, the technical spirit and scope of the present invention is significant in that both heat radiation and electromagnetic wave transmission may be performed regardless of any position at which the present invention is installed within the corresponding device. Therefore, the industrial applicability of the present invention is recognized in that a heat radiation material configured of a metallic material can be directly applied to a device regardless of the path of the electromagnetic waves.

As described above, the metal and carbon laminate transmitting electromagnetic waves or having a function of heat radiation may have the following advantages. According to the exemplary embodiment of the present invention, the metal and carbon laminate transmitting electromagnetic waves or having a function of heat radiation may be attached to an outer case of diverse devices that is configured of plastic, be equipped inside the device and, most particularly, be capable of enhancing the aesthetic external features of the device along with the heat radiation function by adding a metallic texture when applied to the outer case.

According to the exemplary embodiment of the present invention, the metal and carbon laminate transmitting electromagnetic waves or having a function of heat radiation may be installed at any position within the device regardless of the moving direction of the electromagnetic waves, thereby enabling an optimal selection of an installation position for heat radiation.

According to the exemplary embodiment of the present invention, the metal and carbon laminate transmitting electromagnetic waves or having a function of heat radiation may eliminate the function of blocking out electromagnetic waves of metal by providing a groove or slit on at least a portion of the conductive layer and may, therefore, maintain the functions of wireless charging, close-range wireless communication (also referred to as near field communication (NFC)), mobile payment, and so on, of the device.

According to the exemplary embodiment of the present invention, the metal and carbon laminate transmitting electromagnetic waves or having a function of heat radiation may maintain its lightweight by implementing a metallic texture so that the usage of its outer case, which is configured of plastic, can be maintained.

According to the exemplary embodiment of the present invention, the metal and carbon laminate transmitting electromagnetic waves or having a function of heat radiation may add diversity in colors that are recognized through the slit formed on an upper frame, by layering a plurality of frames one over another and by applying different colors to each of the metal layers and/or carbon material. Thus, the aesthetic external features of the device may be enhanced.

According to the exemplary embodiment of the present invention, the metal and carbon laminate transmitting electromagnetic waves or having a function of heat radiation may maximize heat radiation efficiency of the device by using the metal and carbon laminate as a heat radiation means, wherein the metal and carbon laminate may be used as a replacement for a carbon material heat radiation element, which corresponds to the related art heat radiation means, or wherein the metal and carbon laminate may be used in combination with the carbon material heat radiation element.

According to the exemplary embodiment of the present invention, the metal and carbon laminate transmitting electromagnetic waves or having a function of heat radiation may enhance the performance of an NFC module and an installation device by amplifying (or increasing) the transmission/reception rate of the NFC module, since the multi-layer structure of the metal and carbon laminate performs the function of an antenna, in case the metal and carbon laminate is layered in a multi-layer structure.

It will be apparent to those skilled in the art that various modifications and variations can be made in this specification without departing from the spirit or scope of this specification. Thus, it is intended that this specification covers the modifications and variations of this invention provided they come within the scope of the appended claims and their equivalents. It is also apparent that such variations of this specification are not to be understood individually or separately from the technical scope or spirit of this specification.

## Claims

1. A metal and carbon laminate transmitting electromagnetic waves or having a function of heat radiation, comprising:
a first layer configured of a carbon material; and
a second layer configured of metal,
wherein a groove is formed on at least one area of the second layer in order to allow the first layer to be exposed, thereby giving a characteristic of electromagnetic wave transmission, or wherein a slit is formed on the first layer along with the groove.

2. The metal and carbon laminate of claim 1, wherein a boundary between the slit or groove and the second layer is formed in one of straight lines, curved lines, and spiral lines and/or wherein the slit is extended to form at least one pattern consisting of one of straight lines, curved lines, and spiral lines.

3. The metal and carbon laminate of claim 1 or 2, wherein the groove is formed or processed by using at least of one of 3D printing, laser treatment, sawing, drilling, cutting, and etching, and
wherein the slit is formed or processed by using at least one of 3D printing, sawing, laser treatment, punching, and etching.

4. The metal and carbon laminate of one of claims 1 to 3, wherein the first layer is formed by using at least of one of 3D printing, spray coating, printing, vacuum evaporation, dipping, transferring, and adhesion,
and/or wherein the second layer is formed by using at least one of 3D printing, plating, coating, printing, vacuum evaporation, molding, pressing, rolling, and adhesion.

5. The metal and carbon laminate of one of claims 1 to 4, wherein the second layer includes aluminum or copper,
and/or wherein a substance of the first layer fills at least a portion of the groove.

6. The metal and carbon laminate of one of claims 1 to 5, wherein the laminate is installed at a position corresponding to a main transmitting direction or a main receiving direction of a transmitting unit or receiving unit of wireless power or wireless charging included in the device.

7. The metal and carbon laminate of one of claims 1 to 6, wherein a plurality of laminates is layered in a multi-layer structure on a near field communication (NFC) module included in the device, thereby amplifying an electromagnetic field.

8. The metal and carbon laminate of claim 7, wherein the plurality of laminates is layered so that patterns of the groove or slit are vertically identical to one another, or that patterns of the groove or slit are alternated, and
wherein an uppermost laminate is required to have a slit formed thereon,
and/or wherein a plurality of laminates is layered one over another, and wherein a color of a lower laminate is recognized through a slit of an upper laminate.

9. The metal and carbon laminate of one of claims 1 to 8, wherein a lower second layer and an upper second layer are configured to have different colors so that the color of the lower second layer is recognized through the slit of the upper laminate,
and/or wherein a lower first layer and an upper first layer are configured to have different colors so that the color of the lower first layer is recognized through the slit of the upper laminate.

10. The metal and carbon laminate of one of claims 1 to 9, wherein the plurality of metal and carbon laminates is layered one over another, and wherein an insulating layer is further included between each laminate, and
wherein the insulating layer corresponds to any one of air, a laminate, and a coating layer.

11. The metal and carbon laminate of claim 10, wherein the insulating layer and the upper laminate are configured to have different colors so that the color of the insulating layer is recognized through the slit of the upper laminate.

12. The metal and carbon laminate of one of claims 1 to 11, wherein, when a slit is formed on an upper laminate, and when the plurality of metal and carbon laminates is layered one over another, a pattern of a lower laminate is configured to not overlap with a pattern of an upper laminate, thereby allowing a groove or slit formed on the lower laminate to be hidden.

13. The metal and carbon laminate of one of claims 1 to 12, wherein the laminate replaces a conventional carbon heat radiation element configured in a device or layered along with the conventional carbon heat radiation element,
and/or wherein the metal and carbon laminate is connected to a substrate so as to be applied to a mobile device and used as an antenna .

14. The metal and carbon laminate of one of claims 1 to 13, wherein an average width of a groove or slit is equal to or less than 2 times an average width between two adjacent grooves or slits,
and/or wherein the groove or slit has a width exceeding 0 and less than or equal to several millimeters (mm).

15. The metal and carbon laminate of one of claims 1 to 14, wherein an area where the groove or slit is formed is larger than an area occupied by a wireless transmitting/receiving module for transmitting electromagnetic waves, and wherein an entire area occupied by the wireless transmitting/receiving module is positioned to overlap with at least a portion of the area where the slit is formed.
